# EUROPEAN PATENT APPLICATION

(11) **EP 4 769 404 A2**
(43) Date of publication of application: **01.07.2026**
(21) Application number: 25215252.5
(22) Date of filing: 12.11.2025
(51) Int. Cl.: G11C 7/22, G11C 11/418, G11C 11/419

(54) **MEMORY DEVICE INCLUDING PULSE GENERATOR**

(30) Priority: 31.12.2024 KR 20240202742
(71) Applicant: Samsung Electronics Co., Ltd., Suwon-si, Gyeonggi-do 16677 (KR)
(72) Inventor: KANG, Jeonseung, 16677 Suwon-si, Gyeonggi-do (KR); KIM, Kiryong, 16677 Suwon-si, Gyeonggi-do (KR); KIM, Sangwoo, 16677 Suwon-si, Gyeonggi-do (KR); LEE, Hyunwoo, 16677 Suwon-si, Gyeonggi-do (KR)
(74) Representative: Kuhnen & Wacker Patent- und Rechtsanwaltsbüro PartG mbB

(57) **Abstract**

Provided is a memory device including a memory cell array (120) including a plurality of memory cells (MC), a row decoder (130) connected to the plurality of memory cells (MC) through a plurality of wordlines (WL1-WLm), a column decoder (140) connected to the plurality of memory cells (MC) through a plurality of bitlines (BLT1- BLTN), and a pulse generator (111) configured to generate an internal clock ICK) based on a clock received from the outside and generate a wordline enable signal (WLES) corresponding to the internal clock (ICK).

## Description

### BACKGROUND

The inventive concept relates to a memory device including a pulse generator, and more particularly, to a static random-access memory (SRAM) device including a pulse generator adjusting the width of a pulse applied to a wordline during a write operation.

SRAM having high-speed operation characteristics is used in cache memory and is one of the digital circuits essential for implementing various processor functions. SRAM is mainly used in portable devices due to its low power consumption and high-speed operation characteristics, compared to other memories.

Due to the demand for high integration and the advancement of semiconductor processes, the width, spacing, and/or height of wires included in the memory device, such as SRAM, may decrease, thereby increasing parasitic elements of the wires. The increased parasitic elements may lead to greater signal delay and unnecessary power consumption during the operation of the memory device. As a result, the influence of the parasitic elements of the wires on the integrated circuit may become more significant. By minimizing the influence of such parasitic elements, the power consumption by the memory device may be reduced.

### SUMMARY

Aspects of the inventive concept provide a method of reducing power consumption during a write operation of a memory device.

The inventive concept is not limited to the objectives mentioned above, and other benefits not mentioned will be clearly understood by those skilled in the art from the following description.

According to an aspect of the inventive concept, a memory device includes a memory cell array comprising a plurality of memory cells, a row decoder connected to the plurality of memory cells through a plurality of wordlines, a column decoder connected to the plurality of memory cells through a plurality of bitlines, and a pulse generator configured to generate an internal clock based on a clock received from outside the memory device and generate a wordline enable signal in response to a corresponding edge of the internal clock, wherein the pulse generator comprises a first delay circuit configured to operate based on a first level of a tracking control signal and a second delay circuit configured to operate based on a second level of the tracking control signal, wherein the pulse generator is configured to provide a first wordline enable signal to the row decoder through the first delay circuit which causes a first delay from the corresponding edge of the internal clock, and to provide a second wordline enable signal to the row decoder through the second delay circuit which causes a second delay from the corresponding edge of the internal clock, and the second delay is shorter than the first delay.

According to another aspect of the inventive concept, a memory device includes a memory cell array comprising a plurality of memory cells, a row decoder connected to the plurality of memory cells through a plurality of wordlines, a column decoder connected to the plurality of memory cells through a plurality of bitlines, and a pulse generator configured to generate an internal clock based on a clock received from outside the memory device and generate a wordline enable signal in response to a corresponding edge of the internal clock, wherein the pulse generator comprises a first switching circuit configured to output a first wordline enable signal to the row decoder based on a first level of a tracking control signal after a first time interval from the corresponding edge of the internal clock, and a second switching circuit configured to output a second wordline enable signal to the row decoder based on a second level of the tracking control signal after a second time interval from the corresponding edge of the internal clock which is shorter than the first time interval, wherein the first time interval is caused by a second delay line which is actively electrically connected to the first switching circuit based on the first level of a tracking control signal.

According to another aspect of the inventive concept, a memory device for communicating with a host includes a memory cell array comprising a plurality of bitcells, a row decoder connected to the memory cell array through a plurality of wordlines, and configured to select a wordline based on a row address, a column decoder connected to the memory cell array through a plurality of bitlines, and configured to select a bitline based on a column address, and a pulse generator configured to generate an internal clock based on a clock received from outside and generate a wordline enable signal in response to a corresponding edge of the internal clock, wherein the pulse generator comprises a first delay circuit configured to operate based on a first level of a tracking control signal, and a second delay circuit configured to operate based on a second level of the tracking control signal, wherein the pulse generator is configured to, upon receiving a write command from the host, provide a first wordline enable signal based on the first level of the tracking control signal to the row decoder through the first delay circuit which causes a first delay for a write operation on selected bitcell, and upon receiving a read command from the host, provide a second wordline enable signal based on the second level of the tracking control signal to the row decoder through the second delay circuit which causes a second delay that is shorter than the first delay for performing read operation on the selected bitcell.

According to another aspect of the inventive concept, a method for operating a memory device including first and second delay circuits includes generating an internal clock based on a clock received from outside the memory device, generating a wordline enable signal corresponding to the internal clock, providing a first wordline enable signal to a row decoder through the first delay circuit which is configured to operate based on a first level of a tracking control signal and cause a first delay from a corresponding edge of the internal clock, and providing a second wordline enable signal to the row decoder through the second delay circuit which is configured to operate based on a second level of the tracking control signal and cause a second delay from the corresponding edge of the internal clock, wherein the second delay is shorter than the first delay. The method further includes activating a wordline of the memory device in response to the first wordline enable signal to perform a write operation, and activating a wordline of the memory device in response to the second wordline enable signal to perform a read operation, wherein the first wordline enable signal is transitioned to an activation level after a first interval from the corresponding rising edge of the internal clock, the second wordline enable signal is transitioned to an activation level after a second interval from the corresponding rising edge of the internal clock, and the first interval is longer than the second interval, wherein a pulse width of the first wordline enable signal is shorter than a pulse width of the second wordline enable signal.

### BRIEF DESCRIPTION OF THE DRAWINGS

Embodiments will be more clearly understood from the following detailed description taken in conjunction with the accompanying drawings in which:
FIG. 1 is a diagram of a system according to an embodiment;
FIG. 2 is a diagram of a memory device according to an embodiment;
FIG. 3 is a diagram illustrating a memory cell according to an embodiment;
FIG. 4 is a diagram of the memory device according to an embodiment;
FIG. 5 is a diagram of the memory device according to an embodiment;
FIGS. 6A and 6B are diagrams of the memory device according to an embodiment;
FIG. 7 is a timing diagram of signals related to the operation of the memory device, according to an embodiment;
FIG. 8 is a diagram of the memory device according to an embodiment;
FIGS. 9A and 9B are diagrams of the memory device according to an embodiment;
FIGS. 10A and 10B are diagrams illustrating voltages of signals related to the operation of the memory device, according to an embodiment; and
FIG. 11 is a block diagram of a system-on-a-chip according to an embodiment.

### DETAILED DESCRIPTION OF THE EMBODIMENTS

Hereinafter, embodiments are described in detail with reference to the accompanying drawings. When described with reference to the drawings, the same or corresponding components are denoted by the same reference numerals and overlapping descriptions are omitted.

It will be understood that, although the terms first, second, third etc. may be used herein to describe various elements or components, these elements or components should not be limited by these terms. Unless the context indicates otherwise, these terms are only used to distinguish one element or component from another element or component. Thus, a first element or component discussed below in one section of the specification could be termed as a second element or component in another section of the specification or in the claims without departing from the teachings of the present invention. In addition, in certain cases, even if a term is not described using "first," "second," etc., in the specification, it may still be referred to as "first" or "second" in a claim in order to distinguish different claimed elements from each other.

Throughout the specification, when a component is described as "including" a particular element or group of elements, it is to be understood that the component is formed of only the element or the group of elements, or the element or group of elements may be combined with additional elements to form the component, unless the context indicates otherwise.

When a component is described as "actively electrically connected," it refers to that the active component is actually set to allow signals/voltage to pass.

Items described in the singular herein may be provided in plural. Thus, the description of a single item that is provided in plural should be understood to be applicable to the remaining plurality of items unless context indicates otherwise.

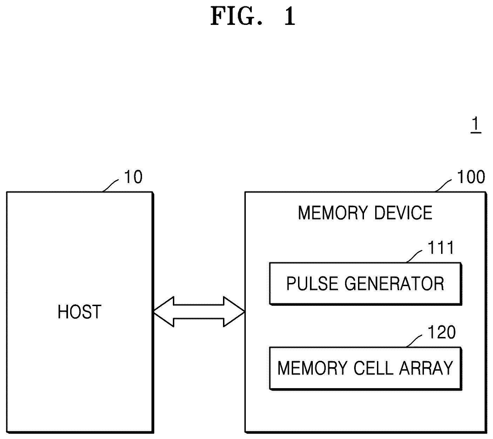

FIG. 1 is a diagram of a system 1 according to an embodiment.

Referring to FIG. 1, the system 1 may include a host 10 and a memory device 100. The host 10 may include a device capable of processing data, such as a central processing unit (CPU), a processor, a microprocessor, or an application processor (AP). The host 10 may execute an operating system (OS) and/or various applications. For example, an electronic device according to an embodiment may be implemented as a mobile device, where the host 10 may be implemented as an AP or a system-on-a-chip (SoC). Accordingly, the host 10 may be embedded in the mobile device.

The host 10 may transmit a request signal requesting a particular operation to the memory device 100 and receive a response signal from the memory device 100. For example, the host 10 may transmit a read request signal and an address to the memory device 100 and the memory device 100 may read data stored in a memory region corresponding to the address. The read request signal may include a signal requesting to read data stored in the memory device 100 and may be a read command. In another example, the host 10 may transmit a write request signal, data, and an address to the memory device 100, and the memory device 100 may store the data in the memory region corresponding to the address. The write request signal may include a signal requesting to write the data in the memory device 100 and may be a write command.

The host 10 may provide an internal voltage and a clock to the memory device 100 to drive the memory device 100. The memory device 100 may operate properly while receiving power. Specifically, the memory device 100 may store data provided from the host 10 or provide the stored data to the host 10 while receiving power. In some embodiments, the memory device 100 may be a volatile memory. For example, the memory device 100 may be implemented as static random-access memory (SRAM).

In some embodiments, the memory device 100 may be controlled by a memory controller implemented separately from the host 10.

The memory device 100 may include a memory cell array 120 and a pulse generator 111. The memory device 100 may write data in the memory cell array 120 in response to the write request signal or read data stored in the memory cell array 120 in response to the read request signal from the host 10.

The memory device 100 may generate, through the pulse generator 111, a wordline enable signal for activating a wordline of the memory cell array 120. In this specification, the wordline enable signal generated in response to the write request signal from the host 10 may be a first wordline enable signal. The wordline enable signal generated in response to the read request signal from the host 10 may be a second wordline enable signal.

In this specification, a selected wordline may refer to a wordline that is connected to a memory cell to be written or read by the write request signal or the read request signal of the host 10 and that is activated by the wordline enable signal. An unselected wordline may refer to wordlines other than the selected wordline.

In this specification, a selected bitcell may refer to a memory cell to be written or read by the write request signal or the read request signal of the host 10 among a plurality of memory cells connected to the selected wordline. A half-selected bitcell may refer to a memory cell which is selected by the wordline, but is not selected by the bitline, and actual write or read operation is not performed on the memory cell. An unselected bitcell may refer to a memory cell connected to the unselected wordline.

The voltage level of the selected wordline may be transitioned by the wordline enable signal generated in response to the write request signal or the read request signal received from the host 10. A time point at which the voltage level of the wordline is transitioned from a first voltage level (e.g., a voltage level corresponding to logic "0") to a second voltage level (e.g., a voltage level corresponding to logic "1") by the wordline enable signal may include a time point at which the wordline is activated. A time point at which the voltage level of the wordline is transitioned from the second voltage level to the first voltage level by the wordline enable signal may include a time point at which the wordline is deactivated.

In an embodiment, when the request signal received from the host 10 is the write request signal, the voltage level of the selected wordline may not be transitioned (e.g., transitioned from the voltage level corresponding to logic "0" to the voltage level corresponding logic "1") directly in response to the write request signal from the host 10 but may be transitioned after a certain period of time. A time point at which the voltage level of the selected wordline is transitioned may include a time point at which a voltage of a bitline of the selected bitcell becomes lower than a reference value as the bitline of the selected bitcell is discharged. The reference value may refer to a voltage that is about 70% lower than the voltage of the bitline of the selected bitcell before being discharged. However, this is an example for convenience of description and is not intended to limit the inventive concept.

The memory device 100 may activate the selected wordline after the bitline of the selected bitcell is sufficiently developed by delaying the time point at which the voltage level of the selected wordline is transitioned in response to the write request signal from the host 10. Accordingly, the power consumed by the memory device 100 according to an embodiment to perform a write operation may be reduced.

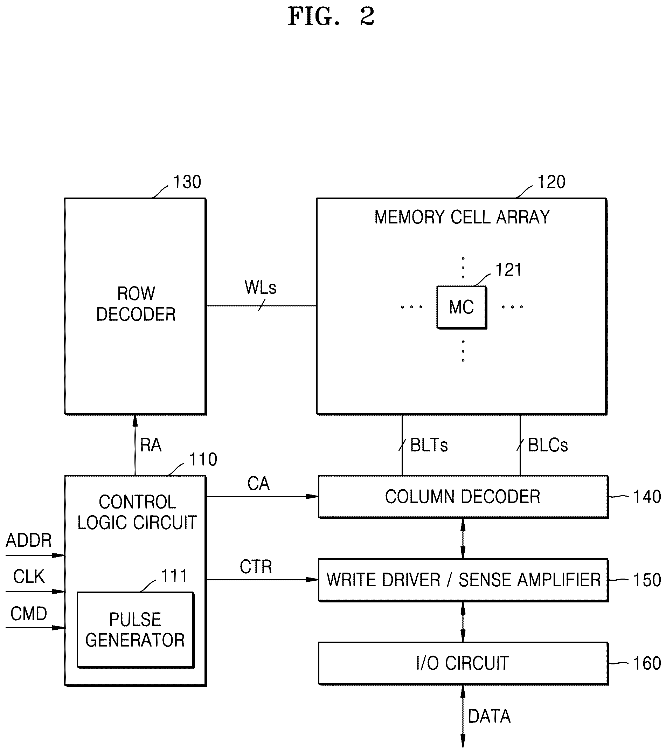

FIG. 2 is a diagram of the memory device 100 according to an embodiment. FIG. 2 may be described with reference to FIG. 1 and overlapping descriptions may be omitted.

Referring to FIG. 2, the memory device 100 according to an embodiment may receive a command CMD, an address ADDR, a clock CLK, and data DATA during the write operation. For example, the memory device 100 may receive the command CMD instructing to write, the address ADDR, and the data DATA and may store the data DATA in a memory cell region corresponding to the address ADDR in the memory cell array 120. The memory cell region may include a memory region including one or more memory cells. During the write operation, the command CMD may be a write command CMD_W, and the data DATA may be write data DATA_W. The memory device 100 may write the write data DATA_W into a memory cell corresponding to the ADDR in response to the write command CMD_W.

The memory device 100 according to an embodiment may receive a command CMD, an address ADDR, and the clock CLK during a read operation. For example, the memory device 100 may receive the command CMD instructing to read and the address ADDR, may read data stored in the memory cell region corresponding to the address ADDR and output the read data to the outside as the data DATA. During the read operation, the command CMD may be a read command CMD_R, and the data DATA may be read data DATA_R. The memory device 100 may read the read data DATA_R from a memory cell corresponding to the address ADDR in response to the read command CMD_R.

The memory device 100 may include a control logic circuit 110, a memory cell array 120, a row decoder 130, a column decoder 140, a write driver/sense amplifier 150, and an input/output (I/O) circuit 160.

The control logic circuit 110 may receive the command CMD, the address ADDR, and the clock CLK and may generate a row address RA, a column address CA, and a control signal CTR. For example, the control logic circuit 110 may identify the read command by decoding the command CMD and may generate the row address RA, the column address CA, and the control signal CTR to read the data DATA from the memory cell array 120. In addition, the control logic circuit 110 may identify the write command by decoding the command CMD and may generate the row address RA, the column address CA, and the control signal CTR to write the data DATA to the memory cell array 120. Alternatively, the address ADDR may include a row address RA and a column address CA. The control logic circuit 110 may identify memory cells with the row address RA and the column address CA for performing the read operation on the memory cells. Likewise, the control logic circuit 110 may identify memory cells with the row address RA and the column address CA for performing the write operation on the memory cells.

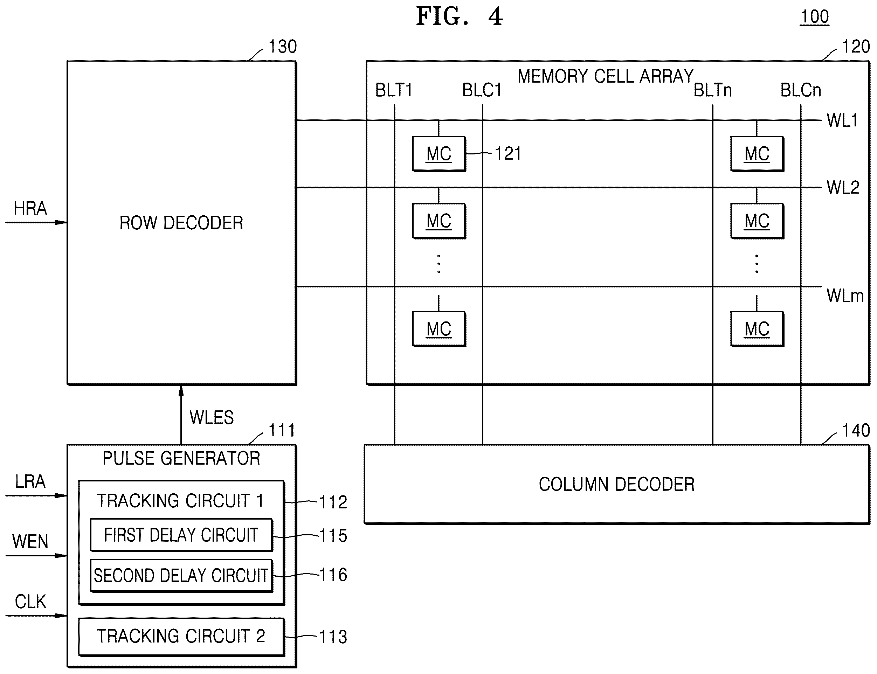

The control logic circuit 110 may include the pulse generator 111. The pulse generator 111 may generate the wordline enable signal based on the clock CLK, the command CMD, and the address ADDR provided from the host 10. The pulse generator 111 is described in detail below with reference to FIG. 4.

In an embodiment, the address ADDR received from the host 10 may include the row address RA and the column address CA. The row address RA may include a plurality of address bits. Upper k bits among the plurality of address bits, where k is a natural number of 2 or greater, may be a high row address and remaining address bits among the plurality of address bits may be a low row address.

The memory cell array 120 may include a plurality of memory cells 121. The plurality of memory cells 121 may be arranged at regular intervals across the memory cell array 120. The plurality of memory cells 121 may be connected to wordlines WLs, and bitlines BLs. The bitlines BLs may include (true) bitlines BLTs and complementary bitlines BLCs. Specifically, the plurality of memory cells 121 may be arranged at intersections of the wordlines WLs, the bitlines BLTs, and the complementary bitlines BLCs. More specifically, each of the plurality of memory cells 121 may be connected to a corresponding wordline among the wordlines WLs, a corresponding bitline among the bitlines BLTs, and a corresponding complementary bitline among the complementary bitlines BLCs.

The row decoder 130 may be connected to the memory cell array 120 through the plurality of wordlines WLs. The row decoder 130 may activate, based on the row address RA, at least one of the plurality of wordlines WLs. That is, the row decoder 130 may select at least one wordline among the plurality of wordlines WLs. Accordingly, memory cells connected to the activated wordline may be selected from among the plurality of memory cells 121. The activated wordline based on the row address RA may be a selected wordline.

In some embodiments, the control logic circuit 110 may provide the high row address as a part of the row address RA to the row decoder 130.

The column decoder 140 may be connected to the memory cell array 120 through the plurality of bitlines BLTs and the plurality of complementary bitlines BLCs. The column decoder 140 may select at least one of the plurality of bitlines BLTs based on the column address CA. The bit line selected by the column decoder 140 may be a selected bitline.

The write driver/sense amplifier 150 may receive write data DATA_W from the I/O circuit 160 and write the write data DATA_W into corresponding memory cells. Additionally, the write driver/sense amplifier 150 may amplify voltage difference between the selected bit line and the selected complementary bit line, and transfer the amplified voltage to the I/O circuit 160 as read data DATA_R. The write driver/sense amplifier 150 may operate as a write driver or as a sense amplifier depending on the voltage level of the control signal CTR. For example, the write driver/sense amplifier 150 may, during the write operation, write the write data DATA_W to corresponding memory cells of the plurality of memory cells 121 connected to the activated wordline by applying a current and/or a voltage to the plurality of bitlines BLTs based on the write data DATA_W. The write driver/sense amplifier 150, during the read operation, may amplify data stored in the memory cells of the plurality of memory cells 121 connected to the activated wordline by sensing the current and/or voltage of the plurality of bitlines BLTs. The amplified data may be output as the read data DATA_R.

According to an embodiment, the column decoder 140 and the write driver/sense amplifier 150 may be implemented as one column driver. The column driver may select a bitline from among the plurality of bitlines BLTs according to the column address CA and operate as a write driver or as a sense amplifier according to the voltage level of the control signal CTR.

The I/O circuit 160 may provide the write data DATA_W to the write driver/sense amplifier 150, and may output the read data DATA_R received from the write driver/sense amplifier 150 to an external device.

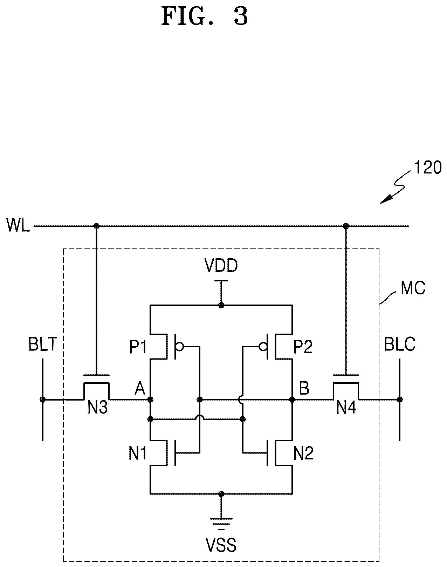

FIG. 3 is a diagram illustrating a memory cell MC according to an embodiment.

Referring to FIG. 3, the memory cell array 120 shown in FIG. 3 may include the memory cell MC. When the memory cell array 120 shown in FIG. 3 is implemented as SRAM, the memory cell MC may be an SRAM cell composed of six transistors. The memory cell MC may be referred to as a six-transistors (6T) SRAM cell. However, it is not limited thereto. The memory cell MC may be an eight-transistors (8T) SRAM cell composed of eight transistors. Hereinafter, it is assumed that the memory cell MC is the 6T SRAM cell.

The memory cell MC may include first and second PMOS transistors P1 and P2 and first to fourth NMOS transistors N1, N2, N3, and N4. The first PMOS transistor P1 may be connected between a power supply voltage VDD and a node A and the second PMOS transistor P2 may be connected between the power supply voltage VDD and a node B. The first NMOS transistor N1 may be connected between a ground voltage VSS and the node A and the second NMOS transistor N2 may be connected between the ground voltage VSS and the node B. The node A may be connected to each gate of the second PMOS transistor P2 and the second NMOS transistor N2. The node B may be connected to each gate of each of the first PMOS transistor P1 and the first NMOS transistor N1. The node A and the node B may be connected to the bitline BLT and complementary bitline BLC by the third NMOS transistor N3 and the fourth NMOS transistor N4, respectively. The gates of the third and fourth NMOS transistors N3 and N4 may be connected to the wordline WL. The third and fourth NMOS transistors N3 and N4 may be access transistors or pass transistors. In some embodiments, the bitline BLT may be a true bitline.

The memory cell MC may store data and complementary data in the node A and the node B and maintain the same in a latched state. Specifically, when the wordline WL is activated during the write operation, the data transferred to the bitline BLT and the complementary bitline BLC through the third and fourth NMOS transistors N3 and N4 may be latched to the node A and the node B. In the memory cell MC, when the wordline WL is activated during the read operation, the data latched to the node A and the node B may be transferred to the bitline BLT and the complementary bitline BLC through the third and fourth NMOS transistors N3 and N4.

In another embodiment, the memory cell MC may include a first inverter and a second inverter. The first inverter may be composed of the first PMOS transistor P1 and the first NMOS transistor N1. The second inverter may be composed of the second PMOS transistor P2 and the second NMOS transistor N2.

FIG. 4 is a diagram of the memory device 100 according to an embodiment. FIG. 4 may be described with reference to FIGS. 1 and 2 and overlapping descriptions may be omitted.

Referring to FIG. 4, the memory device 100 of FIG. 4 may correspond to the memory device 100 of FIG. 2. However, unlike FIG. 2, only the pulse generator 111, the memory cell array 120, the row decoder 130, and the column decoder 140 are shown in the memory device 100 of FIG. 4 for convenience of description.

The pulse generator 111 may include a first tracking circuit 112 and a second tracking circuit 113. The pulse generator 111 may receive a clock CLK, a low row address LRA, and a tracking control signal WEN.

In an embodiment, the control logic circuit 110 may receive a row address RA including a plurality of row address bits. Upper k bits among the plurality of row address bits, where k is a natural number of 2 or greater, may be a high row address HRA, and remaining address bits (e.g., lower 2 bits) among the plurality of address bits may be a low row address LRA. The high row address HRA may be provided to the row decoder 130, and the low row address LRA may be provided to the pulse generator 111. In some embodiments, the low row address LRA may be a decoded row address.

In an embodiment, the tracking control signal WEN may be generated based on a signal included in the command CMD received from the host 10. Alternatively, the tracking control signal WEN may be generated based on a signal generated by the control logic circuit 110 which performs a decoding operation based on the command CMD. For example, when the command CMD received from the host 10 is a write command CMD_W, the voltage level of the tracking control signal WEN may be the first voltage level (e.g., the voltage level corresponding to logic "0"). For example, when the command CMD received from the host 10 is a read command CMD_R, the voltage level of the tracking control signal WEN may be the second voltage level (e.g., the voltage level corresponding to logic "1").

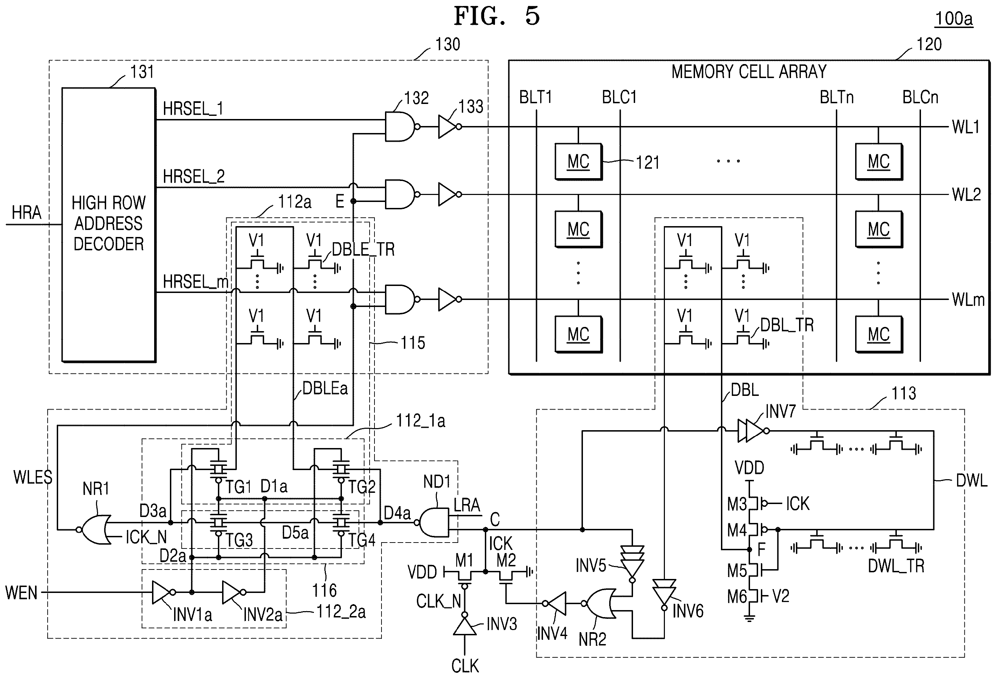

The pulse generator 111 may generate a wordline enable signal WLES based on the clock CLK. The wordline enable signal WLES is described in detail below with reference to FIGS. 5 to 9B.

The first tracking circuit 112 may be configured to determine an activation time point at which the selected wordline is activated. The first tracking circuit 112 may set the activation time point differently based on the attribute of the command CMD received from the host 10. For example, the activation time point at which the wordline is activated may be set differently depending on whether the command CMD received from the host 10 is a write command COM_W or a read command_R. The first tracking circuit 112 may include a first delay circuit 115 configured to operate based on a first level of a tracking control signal and a second delay circuit 116 configured to operate based on a second level of the tracking control signal. The pulse generator may provide a first wordline enable signal to the row decoder 130 through the first delay circuit 115 which causes a first delay from a corresponding edge of the internal clock, and provide a second wordline enable signal to the row decoder 130 through the second delay circuit 116 which causes a second delay from a corresponding edge of the internal clock, and the second delay may be shorter than the first delay. The first delay circuit 115 may include a first transmission gate and a second transmission gate which are turned on in response to the first level of the tracking control signal WEN and a first delay line between the first transmission gate and the second transmission gate, and the second delay circuit 116 may include a third transmission gate and a fourth transmission gate which are turned on in response to the second level of the tracking control signal WEN. The row decoder 130 may activate a wordline among the plurality of wordlines in response to a first wordline enable signal WLES to perform a write operation, and may activate a wordline in response to a second wordline enable signal WLES to perform a read operation.

The second tracking circuit 113 may be configured to determine a deactivation time point at which the selected wordline is deactivated. Although the activation time point at which the selected wordline is activated may be set differently based on the attribute of the command CMD received from the host 10 by the first tracking circuit 112, the deactivation time point at which the selected wordline is deactivated may be set to the same regardless of the attribute of the command CMD. For example, the deactivation time point at which the wordline is deactivated in response to either the write command COM_W or the read command_R may be set to the same.

The row decoder 130 may be connected to the plurality of memory cells 121 through first to m^{th} wordlines WL1 to WLm (m is a natural number of 2 or greater).

The column decoder 140 may be connected to the plurality of memory cells 121 through first to n^{th} bitlines BLT1 to BLTn (n is a natural number of 2 or greater) and first to n^{th} complementary bitlines BLC1 to BLCn.

FIG. 5 is a diagram of a memory device 100a according to an embodiment. FIG. 5 may be described with reference to FIGS. 1 to 4 and overlapping descriptions may be omitted.

Referring to FIG. 5, the memory device 100a of FIG. 5 may correspond to the memory device 100 of FIG. 4. However, unlike in FIG. 4, some components are omitted in the memory device 100a for convenience of description.

The memory device 100a may include a first tracking circuit 112a, the second tracking circuit 113, the memory cell array 120, and the row decoder 130. The first tracking circuit 112a may correspond to the first tracking circuit 112 in FIG. 4.

The first tracking circuit 112a may be connected to the second tracking circuit 113 through a node C. A transistor M1 may be connected to a transistor M2 through the node C. The transistor M1, the transistor M2, and an inverter INV3 may be included in the pulse generator 111.

The transistor M1 may be a PMOS transistor, and an inverted clock CLK_N may be provided to a gate terminal of the transistor M1. The inverted clock CLK_N may include a signal obtained by inverting the clock CLK through the inverter INV3. The power supply voltage VDD may be applied to a first end of the transistor M1, and a second end of the transistor M1 may be connected to the node C. A gate terminal of the transistor M2 may be connected to an inverter INV4, a first end of the transistor M2 may be connected to the node C, and the ground voltage VSS may be applied to a second end of the transistor M2. An internal clock ICK generated based on the clock CLK may be applied to the node C. The pulse width of the internal clock ICK may be greater than the pulse width of the clock CLK.

The first tracking circuit 112a may include a NAND gate ND1, a switching circuit 112_1a, an inverter circuit 112_2a, a NOR gate NR1, a first delay line DBLEa, and a plurality of transistors DBLE_TR. The first tracking circuit 112a may generate the wordline enable signal WLES based on the low row address LRA, the internal clock ICK, and the tracking control signal WEN.

The NAND gate ND1 may receive the low row address LRA through a first input terminal and may receive the internal clock ICK through a second input terminal. An output terminal of the NAND gate ND1 may be connected to the switching circuit 112_1a through a node D4a.

The switching circuit 112_1a may include first to fourth transmission gates TG1 to TG4. A PMOS gate of a first transmission gate TG1, a PMOS gate of a second transmission gate TG2, an NMOS gate of a third transmission gate TG3, and an NMOS gate of a fourth transmission gate TG4 may be connected to each other through a node D1a. An NMOS gate of the first transmission gate TG1, an NMOS gate of the second transmission gate TG2, a PMOS gate of the third transmission gate TG3, and a PMOS gate of the fourth transmission gate TG4 may be connected to each other through a node D2a. A first end of the first transmission gate TG1 may be connected to a node D3a and a second end thereof may be connected to first end of the first delay line DBLEa. A first end of the second transmission gate TG2 may be connected to the node D4a and a second end thereof may be connected to second end of the first delay line DBLEa. A first end of the third transmission gate TG3 may be connected to the node D3a and a second end thereof may be connected to a node D5a. A first end of the fourth transmission gate TG4 may be connected to the node D4a and a second end thereof may be connected to the node D5a.

The inverter circuit 112_2a may include an inverter INV1a and an inverter INV2a. The inverter INV1a may receive the tracking control signal WEN through an input terminal thereof. An output terminal of the inverter INV1a may be connected to the node D2a. An input terminal of the inverter INV2a may be connected to the output terminal of the inverter INV1a through the node D2a. An output terminal of the inverter INV2a may be connected to the node D1a.

The first input terminal of the NOR gate NR1 may be connected to the third node D3a. The NOR gate NR1 may be connected to the switching circuit 112_1a through the first input terminal thereof. The NOR gate NR1 may receive an inverted internal clock ICK_N through the second input terminal thereof. The inverted internal clock ICK_N may include a signal obtained by inverting the internal clock ICK through an inverter (not shown). An output terminal of the NOR gate NR1 may be connected to a node E. The wordline enable signal WLES may be output through the output terminal of the NOR gate NR1.

The first end of the first delay line DBLEa may be connected to the first transmission gate TG1 and the second end thereof may be connected to the second transmission gate TG2. A first voltage V1 may be applied to a gate terminal of each of the plurality of transistors DBLE_TR. The first voltage V1 may be a voltage generated by the control logic circuit 110, e.g., 0 V. The first voltage V1 may be a voltage for turning off the plurality of transistors DBLE_TR. A first end of each of the plurality of transistors DBLE_TR may be connected to the first delay line DBLEa, and the ground voltage may be applied to a second end thereof.

The first delay line DBLEa may be configured to have a first delay that corresponds to the delay experienced by a bitline among the first bitline BLT1 to the n^{th} bitline BLTn. For example, the length of the first delay line DBLEa may be equal to the length of the first bitline BLT1. The resistance of the first delay line DBLEa may be equal to the resistance of the first bitline BLT1. The capacitance of the first delay line DBLEa and the plurality of transistors DBLE_TR connected to the first delay line DBLEa may be equal to the capacitance of the first bitline BLT1 to which memory cells are connected. The resistance and capacitance of the first delay line DBLEa and the plurality of transistors DBLE_TR may be proportional to the length of the first delay line DBLEa. The resistance-capacitance product of the first delay line DBLEa may be adjusted have a first delay that matches a delay experienced by the first bitline BLT1 so that the first delay caused by the first delay line DBLEa may represent the delay experienced by first bitline BLT1. In some embodiments, the first delay line DBLEa may be a first metal line.

The row decoder 130 may include a high row address decoder 131, a plurality of NAND gates 132, and a plurality of inverters 133. The row decoder 130 may select a wordline for performing a read or write operation on memory cells connected to the selected wordline based on the high row address HRA and the wordline enable signal WLES.

The high row address decoder 131 may output, based on the high row address HRA, high address selection signals HRSEL1 to HRSELm for selecting wordlines corresponding to the high row address HRA. The low row address LRA may select a wordline among the wordlines corresponding to the high row address HRA. For example, when the low row address LRA is two bits, there may be four wordlines corresponding to the high row address HRA. In this case, the voltage level of the four high address selection signals HRSEL1 to HRSELm may be the second voltage level (the voltage level corresponding to logic "1").

Each of the plurality of NAND gates 132 may receive the high address selection signals HRSEL1 to HRSELm from the high row address decoder 131 through the first input terminal. Each of the plurality of NAND gates 132 may receive the wordline enable signal WLES through the second input terminal. The output terminals of the plurality of NAND gates 132 may be respectively connected to input terminals of the plurality of inverters 133.

Since the high address selection signals HRSEL1 to HRSELm are signals generated based on the high row address HRA and the wordline enable signal WLES is a signal generated based on the low row address LRA, the row decoder 130 may select one wordline (i.e., selected wordline) corresponding to the row address RA from among the first wordline WL1 to the m^{th} wordline WLm based on an input through the first input terminal and an input through the second input terminal of the plurality of NAND gates 132.

The second tracking circuit 113 may include the inverter INV4, an inverter INV5, an inverter INV6, an inverter INV7, a NOR gate NR2, a second wire DWL, a plurality of transistors DWL_TR, a third wire DBL, a plurality of the transistors DBL_TR, and third to sixth transistors M3 to M6. The transistor M3 and the transistor M4 may be PMOS transistors. The transistor M5 and the transistor M6 may be NMOS transistors.

An output terminal of the inverter INV4 may be connected to a gate of the transistor M2, and an input terminal of the inverter INV4 may be connected to an output terminal of the NOR gate NR2.

A first input terminal of the NOR gate NR2 may be connected to an output terminal of the inverter INV5, and a second input terminal of the NOR gate NR2 may be connected to an output terminal of the inverter INV6.

Input terminals of the inverter INV5 and the inverter INV7 may be connected to the node C.

A first end of the second wire DWL may be connected to an output terminal of the inverter INV7 and a second end thereof may be connected to a gate of the transistor M4. A gate terminal of each of the plurality of transistors DWL_TR may be connected to the second wire DWL. The ground voltage may be applied to a source terminal and a drain terminal of each of the plurality of transistors DWL_TR.

The second wire DWL may cause a second wire delay that matches a delay experienced by a wordline among the first wordline WL1 to the m^{th} wordline WLm. For example, the length of the first wordline WL1 may correspond to the length of the second wire DWL. The resistance of the first wordline WL1 may correspond to the resistance of the second wire DWL and the capacitance of the first wordline WL and the memory cells connected to the first wordline DWL may correspond to the capacitance of the second wire DWL and the plurality of transistors DWL_TR. The resistance and capacitance of the second wire DWL and the plurality of transistors DWL_TR may be proportional to the length of the second wire DWL. The resistance-capacitance product of the second wire DWL can be adjusted to have the second wire delay that matches a delay experienced by the first wordline WL so that the second wire delay caused by the second wire DWL may represent the delay experienced by the first wordline WL. In some embodiments, the second wire DWL may be a second metal line.

A first end of the third wire DBL may be connected to an input terminal of the inverter INV6 and a second end thereof may be connected to a node F. The first voltage V1 may be applied to a gate terminal of each of the plurality of transistors DBL_TR. The first voltage V1 may include a voltage for turning off the plurality of transistors DBLE_TR. A first end of each of the plurality of transistors DBL_TR may be connected to the third wire DBL, and the ground voltage may be applied to a second end thereof.

The third wire DBL may cause a third wire delay that matches a delay experienced by a bitline of the first bitline BLT1 to the n^{th} bitline BLTn. For example, the length of the third wire DBL may correspond to the length of the first bitline BLT1. The resistance of the third wire DBL may correspond to the resistance of the first bitline BLT1. The capacitance of the third wire DBL and the plurality of transistors DBLE_TR may correspond to the capacitance of the first bitline BLT1 and the memory cells connected to the first bitline BLT1. The resistance and capacitance of the third wire DBL and the plurality of transistors DBL_TR may be proportional to the length of the third wire DBL. The resistance-capacitance product of the third wire DBL can be adjusted to have the third wire delay that matches the delay experienced by the first bitline BLT1 so that the third wire delay caused by the third wire DBL may represent the delay experienced by the first bitline BLT1. In some embodiments, the third wire DBL may be a third metal line.

The internal clock ICK may be applied to a gate terminal of the transistor M3, the power supply voltage VDD may be applied to a first end of the transistor M3, and a second end of the transistor M3 may be connected to a first end of the transistor M4. A second end of the transistor M4 may be connected to the node F. A gate terminal of the transistor M5 may be connected to the second wire DWL, a first end of the transistor M5 may be connected to the node F, and a second end of the transistor M5 may be connected to a first end of the transistor M6. A second voltage V2 may be applied to a gate terminal of the transistor M6 and the ground voltage may be applied to a second terminal of the transistor M6. The second voltage V2 may include a voltage generated by the control logic circuit 110 and may include a voltage for turning on the transistor M6.

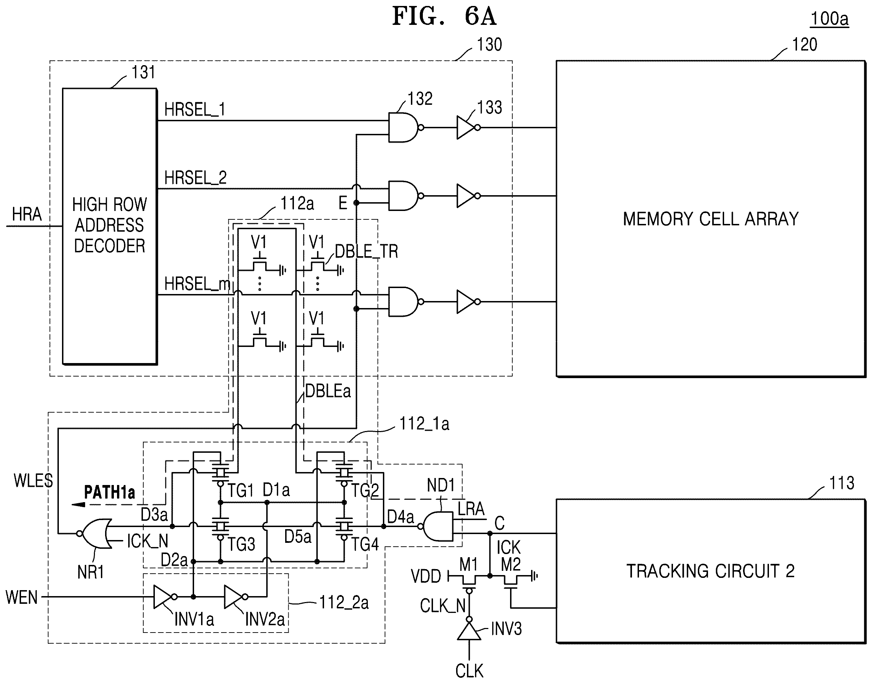

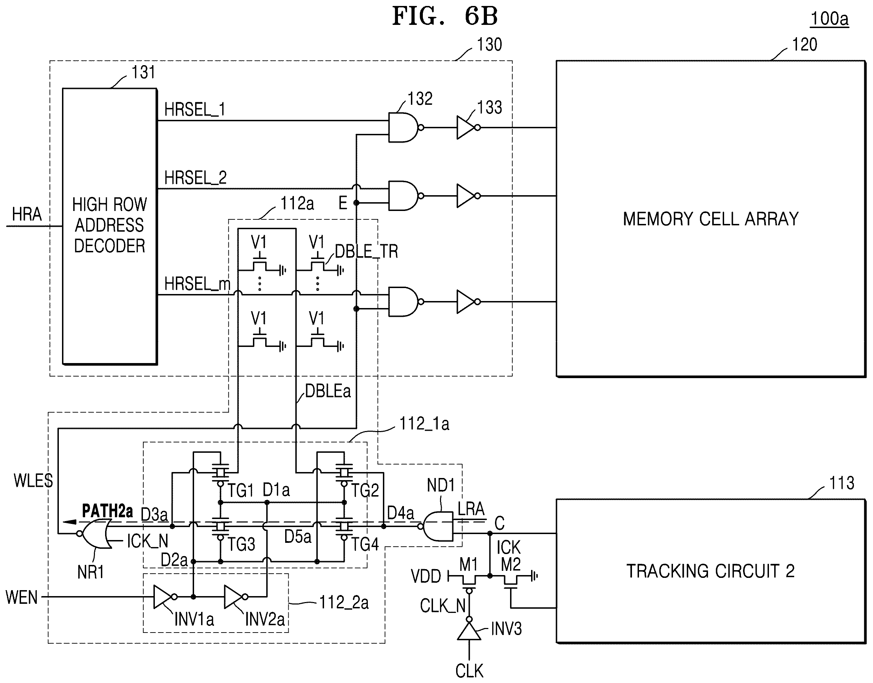

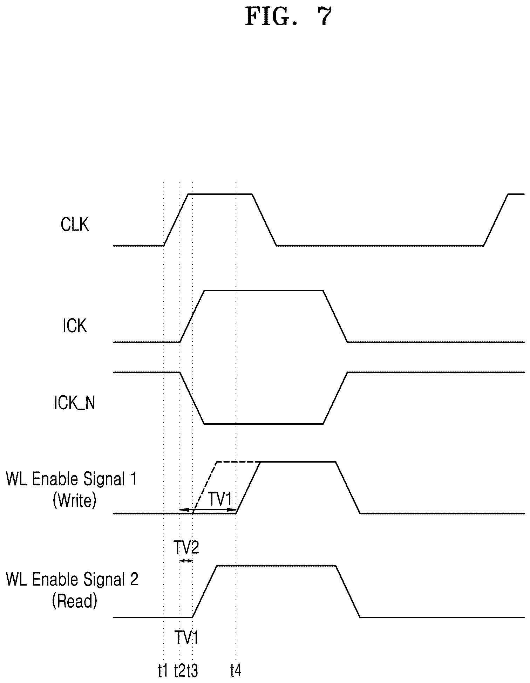

FIGS. 6A and 6B are diagrams of the memory device 100a according to an embodiment. FIG. 7 is a timing diagram of signals related to the operation of the memory device 100a, according to an embodiment. FIGS. 6A, 6B, and 7 may be described with reference to FIGS. 1 to 5 and overlapping descriptions may be omitted.

The memory device 100a of FIGS. 6A and 6B may correspond to the memory device 100a of FIG. 5.

FIG. 6A is a diagram illustrating a case where the host (10 in FIG. 1) writes data to the selected bitcell of the memory cell array 120. The voltage level of a tracking control signal WEN provided to the first tracking circuit 112a may include the first voltage level (e.g., the voltage level corresponding to logic "0").

FIG. 6B is a diagram illustrating a case where the host 10 reads data from the selected bitcell of the memory cell array 120. The voltage level of the tracking control signal WEN provided to the first tracking circuit 112a may be the second voltage level (e.g., the voltage level corresponding to logic "1").

FIG. 7 is a timing diagram illustrating the clock CLK, the internal clock ICK, and the inverted internal clock ICK_N during the write/read operation, the voltage level of the selected wordline during the write operation, and the voltage level of the selected wordline during the read operation of the memory device 100a of FIGS. 6A and 6B.

Referring to FIGS. 6A and 7, since the voltage level of the tracking control signal WEN provided to the first tracking circuit 112a is the first voltage level, the first transmission gate TG1 and the second transmission gate TG2 may be turned on, and the third transmission gate TG3 and the fourth transmission gate TG4 may be turned off. At this time, a first path PATH1a may be activated.

The first tracking circuit 112a may generate the first wordline enable signal as the wordline enable signal WLES. The first wordline enable signal may transition to an activation level in response to transitioning of the internal clock ICK from a first level to a second level. For example, the first wordline enable signal may transition to a logic high level (i.e., the activation level of the first wordline enable signal) at a rising edge of the internal clock ICK. Due to the first delay caused by the first path PATH1a, a time point (the fourth time point t4 of FIG. 7) at which the first tracking circuit 112a generates the first wordline enable signal may be delayed from the rising edge of the internal clock ICK by a first interval TV1.

In an embodiment, the length of the first interval TV1 may be proportional to the magnitude of the resistance-capacitance product of the first delay line DBLEa which may be measured from the resistance of the first delay line DBLEa and the capacitance of the plurality of transistors DBLE_TR connected to the first delay line DBLEa. For example, as the resistance-capacitance product of the first delay line DBLEa and the plurality of transistors DBLE_TR increases, a time point (e.g., the fourth time point t4 of FIG. 7) at which the first wordline enable signal is transitioned may be further delayed.

Referring to FIG. 6B, since the voltage level of the tracking control signal WEN provided to the first tracking circuit 112a is the second voltage level, the first transmission gate TG1 and the second transmission gate TG2 may be turned off, and the third transmission gate TG3 and the fourth transmission gate TG4 may be turned on. At this time, a second path PATH2a may be activated.

The first tracking circuit 112a may generate the second wordline enable signal as the wordline enable signal WLES. The second wordline enable signal may transition to activation level in response to transitioning of the internal clock ICK from a first voltage level to a second voltage level. For example, the second wordline enable signal may transition to a logic high level (i.e., the activation level of the second wordline enable signal) at a rising edge of the internal clock ICK. Due to the delay caused by the second path PATH2a, a time point (e.g., a third time point t3 of FIG. 7) at which the first tracking circuit 112a generates the second wordline enable signal may be delayed from the rising edge of the internal clock ICK by a second interval TV2.

Referring to FIG. 7, the clock CLK provided by the host 10 to the memory device 100a may have a rising edge at a first time point t1.

The internal clock ICK may have the rising edge at the second time point t2, which is a certain amount of time after the first time point t1, in response to the rising edge of the clock CLK. The pulse width of the internal clock ICK may be greater than the pulse width of the clock CLK.

When the memory device 100a performs the write operation on the selected bitcell in response to the request from the host 10, the voltage level of the first wordline enable signal may be transitioned to the second voltage level at the fourth time point t4. The fourth time point t4 may be a delayed time point from the second time point t2 by the first interval TV1.

When the memory device 100a performs the read operation on the selected bitcell in response to the request from the host 10, the voltage level of the second wordline enable signal may be transitioned to the second voltage level at the third time point t3. The third time point t3 may be a delayed time point from the second time point t2 by the second interval TV2. The duration of the first interval TV1 may be longer than the duration of the second interval TV2. Accordingly, the pulse width of the first wordline enable signal may be shorter than that of the second wordline enable signal.

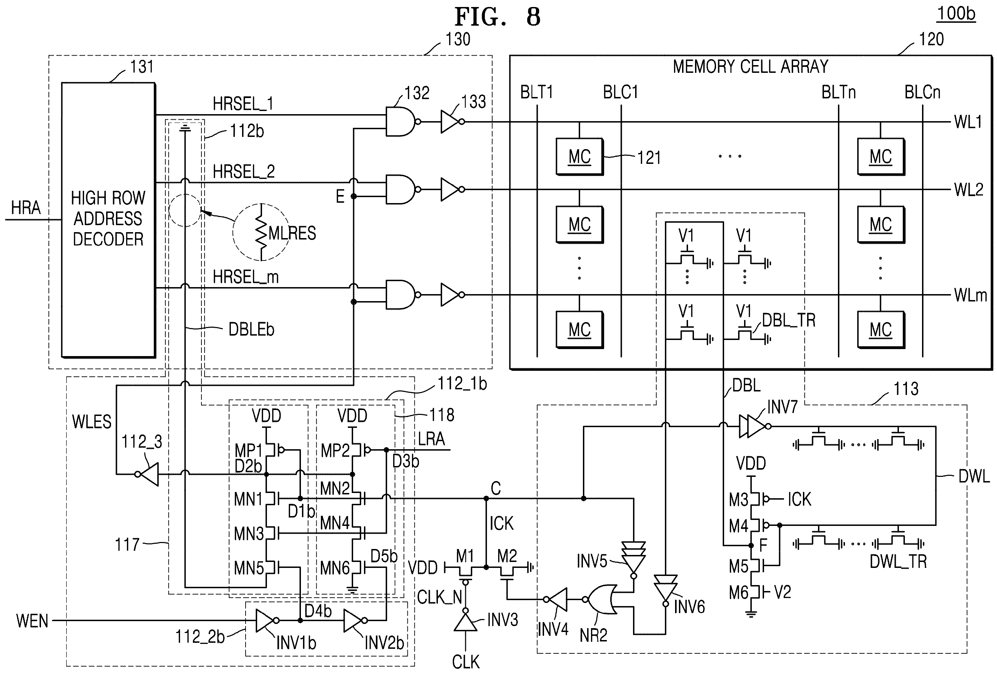

FIG. 8 is a diagram of a memory device 100b according to an embodiment. FIG. 8 may be described with reference to FIGS. 1 to 6B and overlapping descriptions may be omitted.

Referring to FIG. 8, the memory device 100b of FIG. 8 may correspond to the memory device 100 of FIG. 4. However, unlike in FIG. 4, some components are omitted in the memory device 100b of FIG. 8 for convenience of description. The memory device 100b of FIG. 8 may include a first tracking circuit 112b which is different from the first tracking circuit 112a of FIG. 5.

The memory device 100b may include the first tracking circuit 112b, the second tracking circuit 113, the memory cell array 120, and the row decoder 130. The first tracking circuit 112b may correspond to the first tracking circuit 112 of FIG. 4.

The first tracking circuit 112b may include a switching circuit 112_1b, an inverter circuit 112_2b, and an inverter 112_3.

The switching circuit 112_1b may include first and second PMOS transistors MP1 and MP2, and first to sixth NMOS transistors MN1 to MN6. A gate terminal of the first PMOS transistor MP1 may be connected to a node D1b. The power supply voltage VDD may be applied to a first end of the first PMOS transistor MP1. A second end of the first PMOS transistor MP1 may be connected to a node D2b. A gate terminal of the second PMOS transistor MP2 may be connected to a node D3b. The power supply voltage VDD may be applied to a first end of the second PMOS transistor MP2. A second end of the second PMOS transistor MP2 may be connected to the node D2b. A gate terminal of the first NMOS transistor MN1 may be connected to the node D1b. A first end of the first NMOS transistor MN1 may be connected to the node D2b and a second end of the first NMOS transistor MN1 may be connected to a first end of the third NMOS transistor MN3. A gate terminal of the second NMOS transistor MN2 may be connected to the node D1b. A first end of the second NMOS transistor MN2 may be connected to the node D2b and a second end of the second NMOS transistor MN2 may be connected to a first end of the fourth NMOS transistor MN4. A gate terminal of the third NMOS transistor MN3 may be connected to the node D3b. A second end of the third NMOS transistor MN3 may be connected to a first end of the fifth NMOS transistor MN5. A gate terminal of the fourth NMOS transistor MN4 may be connected to the node D3b. A second end of the fourth NMOS transistor MN4 may be connected to a first end of the sixth NMOS transistor MN6. A gate terminal of the fifth NMOS transistor MN5 may be connected to a node D4b. A second end of the fifth NMOS transistor MN5 may be connected to a first end of a second delay line DBLEb. A gate terminal of the sixth NMOS transistor MN6 may be connected to a node D5b. The ground voltage may be applied to a second end of the sixth NMOS transistor MN6. The switching circuit 112_1b may include a first switching circuit 117 and a second switching circuit 118. The first switching circuit 117 may include the first PMOS transistor MP1, the first NMOS transistor MN1, the third NMOS transistor MN3, the fifth NMOS transistor MN5, and the second delay line DBLEb. The second switching circuit 118 may include the second PMOS transistor MP2, the second NMOS transistor MN2, the fourth NMOS transistor MN4, and the sixth NMOS transistor MN6.

The inverter circuit 112_2b may include an inverter INV1b and an inverter INV2b. The inverter INV1b may receive the tracking control signal WEN through an input terminal. An output terminal of the inverter INV1b may be connected to the node D4b. An input terminal of the inverter INV2b may be connected to the output terminal of the inverter INV1b through the node D4b. An output terminal of the inverter INV2b may be connected to the gate terminal of the sixth NMOS transistor MN6 through the node D5b. In some embodiments, the output of the inverter INV1b may be a first tracking control signal, and the output of the inverter INV2b may be a second tracking control signal.

An input terminal of the inverter 112_3 may be connected to the switching circuit 112_1b through the second node D2b. An output terminal of the inverter 112_3 may be connected to the node E. The wordline enable signal WLES may be output through the output terminal of the inverter 112_3.

A first end of the second delay line DBLEb may be connected to the fifth NMOS transistor MN5, and the ground voltage may be applied to a second end thereof.

The second delay line DBLEb may be configured to have a delay similar to a delay experienced by a bitline of the first bitline BLT1 to the n^{th} bitline BLTn. For example, the length of second delay line DBLEb may be equal to the length of first bitline BLT1. A resistance MLRES of the second delay line DBLEb may be equal to the resistance of the first bitline BLT1.

The second delay line DBLEb in FIG. 8 is configured to provide a path for the current to flow out from the switching circuit 112_1b, unlike the first delay line DBLEa in FIG. 5. Thus, the delay caused by the second delay line DBLEb on the first tracking circuit 112b may be less affected from the capacitance of the second delay line DBLEb. Accordingly, FIG. 8 illustrates the resistance MLRES of the second delay line DBLEb, but is not intended to limit the inventive concept.

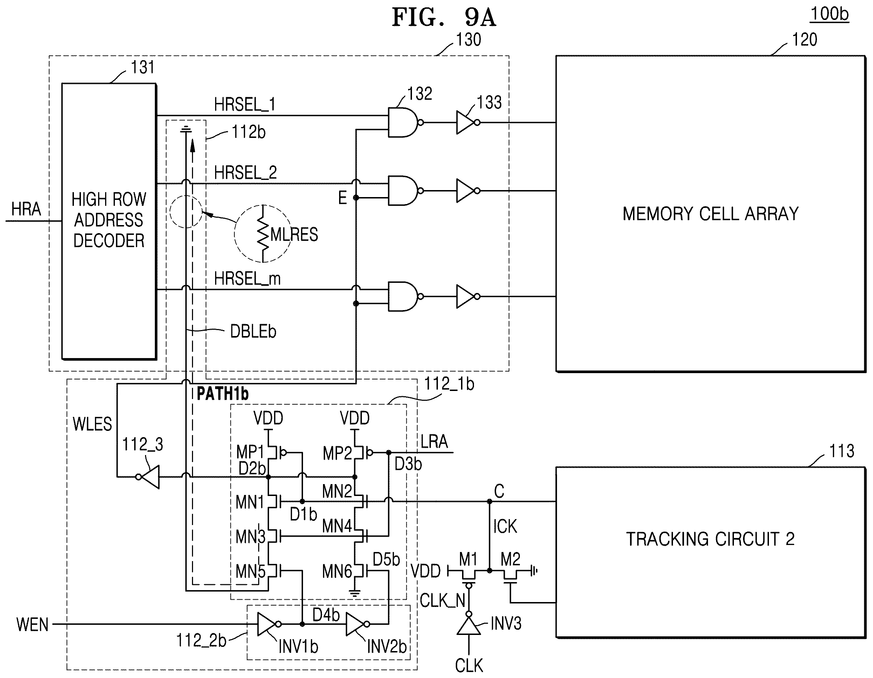

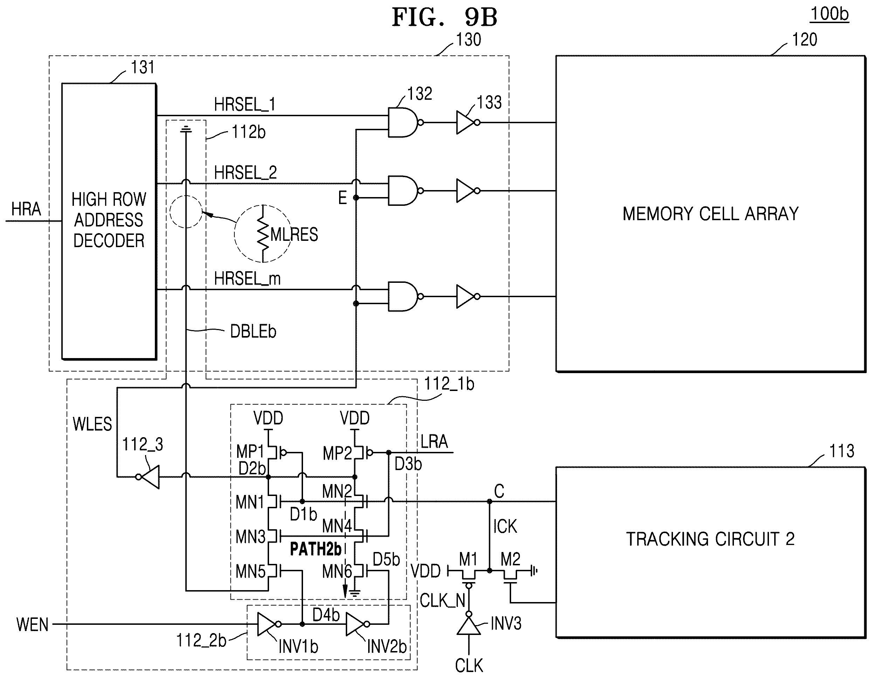

FIGS. 9A and 9B are diagrams of the memory device 100b according to an embodiment. FIGS. 9A and 9B may be described with reference to FIGS. 1 to 8 and overlapping descriptions may be omitted.

The memory device 100b in FIGS. 9A and 9B may correspond to the memory device 100b of FIG. 8.

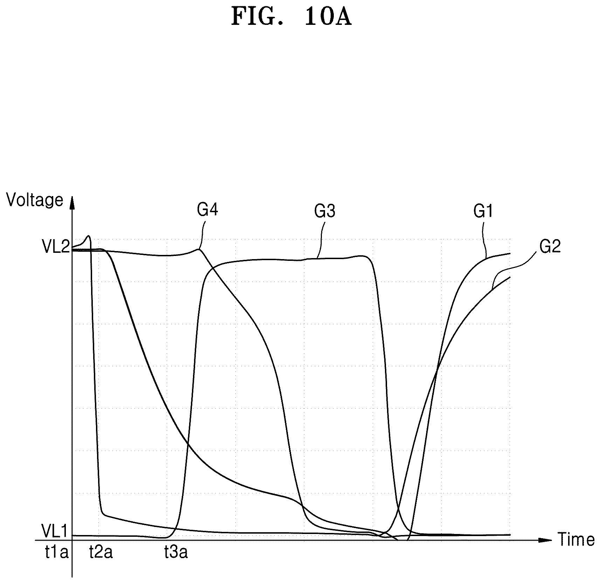

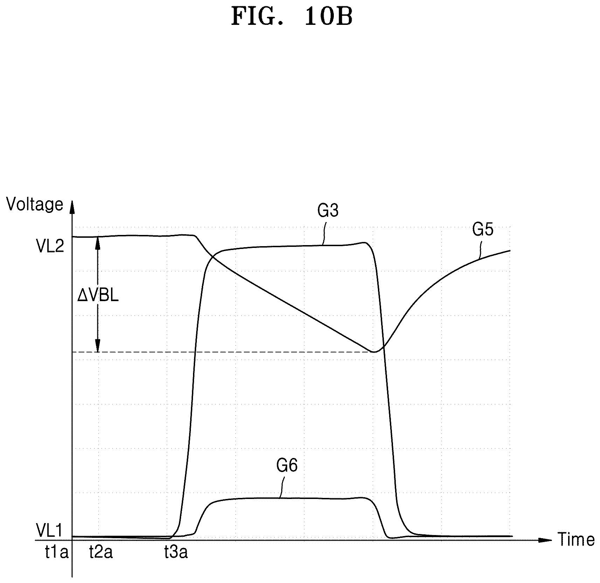

FIG. 9A is a diagram illustrating a case where the host (FIGS. 1 and 10) writes data to the selected bitcell of the memory cell array 120. At this time, the voltage level of the tracking control signal WEN provided to the first tracking circuit 112b may be the first voltage level (e.g., the voltage level corresponding to logic "0").

FIG. 9B is a diagram illustrating a case where the host 10 reads data from the selected bitcell of the memory cell array 120. At this time, the voltage level of the tracking control signal WEN provided to the first tracking circuit 112b may be the second voltage level (e.g., the voltage level corresponding to logic "1").

The signals of the memory device 100b of FIGS. 9A and 9B may also follow the timing diagram of FIG. 7. Hereinafter, the description is made with reference to FIGS. 9A, 9B, and 7 together.

Referring to FIGS. 9A and 7, since the voltage level of the tracking control signal WEN provided to the first tracking circuit 112b is the first voltage level, the fifth NMOS transistor MN5 may be turned on and the sixth NMOS transistor MN6 may be turned off. The second delay line DBLEb may be electrically connected to the switching circuit 112_1b because the fifth NMOS transistor MN5 is turned on.

The first tracking circuit 112b may generate the first wordline enable signal as the wordline enable signal WLES. The first wordline enable signal may transition to an activation level in response to transitioning of the internal clock ICK from a first voltage level to a second voltage level. For example, the first wordline enable signal may transition to a logic high level (e.g., the activation level of the first wordline enable signal) at a rising edge of the internal clock ICK. Since a current path to an activated first path PATH1b is formed by electrically connecting the second delay line DBLEb to the switching circuit 112_1b, the transition of the voltage level of the first wordline enable signal is delayed from the rising edge of the internal clock ICK by a third interval TV3. Accordingly, the time point at which the first tracking circuit 112b generates the first wordline enable signal may be after the third interval TV3 from the transitioning (e.g., rising edge) of the internal clock ICK.

In an embodiment, the length of the third interval TV3 may be proportional to the length of the second delay line DBLEb. The resistance MLRES of the second delay line DBLEb may be increased in proportion to the length of the second delay line DBLEb.

Referring to FIGS. 9B and 7, since the voltage level of the tracking control signal WEN provided to the first tracking circuit 112b is the second voltage level, the fifth NMOS transistor MN5 may be turned off and the sixth NMOS transistor MN6 may be turned on.

The first tracking circuit 112b may generate the second wordline enable signal as the wordline enable signal WLES. The second wordline enable signal may transition to an activation level in response to transitioning of the internal clock ICK from a first voltage level to a second voltage level. For example, the second wordline enable signal may transition to a logic high level which is the activation level of the second wordline enable signal at a rising edge of the internal clock ICK. As the sixth NMOS transistor MN6 is turned on, a current path to the second path PATH2b may be formed. The length of the second path PATH2b may be less than the length of the first path PATH1b, and thus the resistance of the second path PATH2b may be smaller than the resistance MLRES of the second delay line DBLEb. In this case, the time point at which the first tracking circuit 112b generates the second wordline enable signal may be delayed from the transitioning (e.g., rising edge) of the internal clock ICK by a fourth interval TV4.

FIGS. 10A and 10B are diagrams illustrating voltages of signals related to the operation of the memory device 100, according to an embodiment. FIG. 10A is a diagram illustrating a change in voltage levels related to the selected bitcell when the memory device 100 performs the write operation on the selected bitcell. FIG. 10B is a diagram illustrating a change in voltage levels related to the half-selected bitcell when the memory device 100 performs the write operation on the selected bitcell. FIGS. 10A and 10B may be described with reference to FIGS. 1 to 9 and overlapping descriptions may be omitted.

Referring to FIG. 10A, a first graph G1 may represent a voltage applied to the bitline of the selected bitcell by the write driver/sense amplifier 150 for the write operation. A second graph G2 may represent a voltage of the bitline of the selected bitcell. A third graph G3 may represent a voltage of the wordline connected to the selected bitcell. A fourth graph G4 may represent the voltage level of the data stored in the selected bitcell, for example, a voltage of the node A in FIG. 3.

In an embodiment, it is assumed that the memory device 100 receives the write command from the host 10 at or before a first time point t1a. In addition, it is assumed that data "0" is written to the selected bitcell.

In order for the write driver/sense amplifier 150 to write "0" to the selected bitcell at the first time point t1a, the write driver/sense amplifier 150 may drive the first voltage level VL1 to the bitline of the selected bitcell.

At a second time point t2a, the memory device 100 may set the voltage level of the bitline to the first voltage level VL1 through the write driver/sense amplifier 150. Due to the resistance and the capacitance of the bitline, the voltage of the bitline may not immediately drop to the first voltage level VL1 at the second time point t2a, and the voltage level of the bitline may gradually drop over a certain period of time. Therefore, if the wordline of the selected bitcell for the write operation is activated at the second time point t2a, the voltage of the bitline at the selected bitcell does not drop sufficiently enough to perform the write operation. The actual write operation may be performed at a time point (e.g., t3a) at which the bitline voltage at the selected bitcell is developed sufficiently. Because the bitcells of SRAM are composed of latches, the bitcells may consume unnecessary power when the write data are opposite from the data stored in the bitcells. While the write operation is not performed properly at the second time points t2a, some half-selected bitcells may consume power during the write operation period when the stored data in the selected bitcells are opposite from the bitline precharge voltage level.

The memory device 100 according to an embodiment may activate the wordline at a third time point t3a at which the voltage of the bitline has sufficiently dropped (e.g., when the voltage has dropped by about 70% from the second voltage VL2) compared with the voltage of the bitline at the second time point t2a, thereby reducing unnecessary power consumption due to early activation of the wordline during the write operation to the selected bitcell. Because of the reduced duration of wordline activation period, the power consumption at the half-selected bitcells may also be reduced.

Referring to FIG. 10B, a fifth graph G5 may represent a voltage of the bitline or the complementary bitline of the half-selected bitcell. A sixth graph G6 may represent the voltage level of the data stored in the half-selected bitcell, for example, the voltage of the node A in FIG. 3. Because the voltage level of the data stored in the half-selected bitcell of FIG. 3 (e.g., low level) is opposite from the bitline precharge voltage level (e.g., high level), the half-selected bitcell may consume during the write operation period. Furthermore, the memory device may consume additional power to recover the bitline precharge level.

The half-selected bitcell may be connected to the same wordline as the selected bitcell. As the wordline is activated for the write operation to the selected bitcell, the voltage level of the bitline of the half-selected bitcell may be dropped by a voltage difference ΔVBL. Since the voltage of the half-selected bitcell is not subject to the write operation, the voltage level of the half-selected bitcell may be restored to the second voltage level VL2 through a precharge operation as the wordline is deactivated.

The memory device 100 according to an embodiment may delay the time point at which the wordline is activated to the third time point t3a rather than the second time point t2a. As duration of the wordline activation period is reduced, the amount of charge discharged from the bitline of the half-selected bitcell may be reduced. Additionally, the amount of power used to maintain the data voltage level of the half-selected bitcell may be reduced.

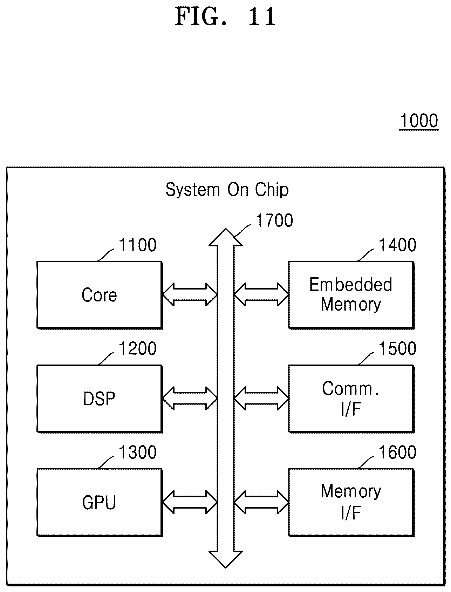

FIG. 11 is a block diagram of a SoC according to an embodiment.

Referring to FIG. 11, a SoC 1000 may refer to an integrated circuit that integrates components of a computing system or another electronic system. For example, as an example of the SoC 1000, the AP may include a processor and components for other functions. As shown in FIG. 11, the SoC 1000 may include a core 1100, a digital signal processor (DSP) 1200, a graphics processing unit (GPU) 1300, embedded memory 1400, a communication interface 1500, and a memory interface 1600. The components of the SoC 1000 may communicate with each other through bus 1700. The components of the SoC 1000 may operate based on a particular supply voltage.

The core 1100 may process instructions and may control the operation of components included in the SoC 1000. For example, the core 1100 may run an OS and execute applications on the OS by processing a series of instructions. The DSP 1200 may generate useful data by processing a digital signal, e.g., a digital signal provided from the communication interface 1500. The GPU 1300 may generate data for an image output through a display device from image data provided from the embedded memory 1400 or the memory interface 1600 and may encode the image data. In some embodiments, the memory device described above with reference to the drawings may be included in the core 1100, the DSP 1200 and/or the GPU 1300 as cache memory and/or a buffer. Accordingly, due to the high reliability and efficiency of the memory device, the core 1100, the DSP 1200, and/or the GPU 1300 may also have high reliability and efficiency.

The embedded memory 1400 may store data necessary for the core 1100, the DSP 1200, and the GPU 1300 to operate. In some embodiments, the embedded memory 1400 may include the memory device described above with reference to the drawings. Accordingly, the embedded memory 1400 may reduce the amount of power consumed to precharge the half-selected bitcell by delaying the time point at which the wordline is activated during the writing operation. As a result, the power efficiency of the SoC 1000 may be improved.

The communication interface 1500 may provide a communication network or an interface for one-to-one communication. The memory interface 1600 may provide an interface to external memory of the SoC 1000, such as dynamic random-access memory (DRAM), flash memory, and the like.

While the inventive concept has been particularly shown and described with reference to embodiments thereof, it will be understood that various changes in form and details may be made therein without departing from the scope of the following claims.

## Claims

1. A memory device (100, 100a) comprising:
a memory cell array (120) comprising a plurality of memory cells (MC);
a row decoder (130) connected to the plurality of memory cells (MC) through a plurality of wordlines (WL1-WLm);
a column decoder (140) connected to the plurality of memory cells (MC) through a plurality of bitlines (BLT1- BLTN); and
a pulse generator (111) configured to generate an internal clock (ICK) based on a clock received from outside the memory device (100, 100a) and generate a wordline enable signal (WLES) in response to a corresponding edge of the internal clock (ICK),
wherein the pulse generator (111) comprises a first delay circuit (115) configured to operate based on a first level of a tracking control signal (WEN) and a second delay circuit (116) configured to operate based on a second level of the tracking control signal (WEN),
wherein the pulse generator (111) is configured to provide a first wordline enable signal to the row decoder (130) through the first delay circuit (115) which causes a first delay (TV1) from the corresponding edge of the internal clock (ICK), and to provide a second wordline enable signal to the row decoder (130) through the second delay circuit (116) which causes a second delay (TV2) from the corresponding edge of the internal clock (ICK), and the second delay (TV2) is shorter than the first delay (TV1).

2. The memory device (100, 100a) of claim 1, wherein the first delay circuit (115) includes a first transmission gate (TG1) and a second transmission gate (TG2) which are turned on in response to the first level of the tracking control signal (WEN) and a first delay line (DBLEa) between the first transmission gate (TG1) and the second transmission gate (TG2), and the second delay circuit (116) includes a third transmission gate (TG3) and a fourth transmission gate (TG4) which are turned on in response to the second level of the tracking control signal (WEN).

3. The memory device (100, 100a) of claim 2, wherein the row decoder (130) is configured to activate a wordline among the plurality of wordlines (WL1-WLm) in response to the first wordline enable signal to perform a write operation and to activate a wordline in response to the second wordline enable signal to perform a read operation.

4. The memory device (100, 100a) of claim 2 or 3, wherein the first delay line (DBLEa) is connected to a plurality of transistors (DBLE_TR), a drain terminal of each of the plurality of transistors (DBLE_TR) is connected to the first delay line (DBLEa), a source terminal of each of the plurality of transistors (DBLE_TR) is configured to receive a ground voltage, and a gate terminal of each of the plurality of transistors (DBLE_TR) is configured to receive a reference voltage (V1).

5. The memory device (100, 100a) of any one of claims 2 to 4, wherein the pulse generator (111) comprises a first inverter (INV1a) and a second inverter (INV2a),
the first inverter (INV1a) receives the tracking control signal (WEN) through an input terminal,
an output terminal of the first inverter (INV1a) is connected to NMOS gate terminals of the first transmission gate (TG1) and the second transmission gate (TG2) and is connected to PMOS gate terminals of the third transmission gate (TG3) and the fourth transmission gate (TG4),
an input terminal of the second inverter (INV2a) is connected to an output terminal of the first inverter (INV1a), and
an output terminal of the second inverter (INV2a) is connected to PMOS gate terminals of the first transmission gate (TG1) and the second transmission gate (TG2) and is connected to NMOS gate terminals of the third transmission gate (TG3) and the fourth transmission gate (TG4).

6. The memory device (100, 100a) of any one of claims 2 to 5, wherein a PMOS gate of the first transmission gate (TG1), a PMOS gate of the second transmission gate (TG2), an NMOS gate of the third transmission gate (TG3), and an NMOS gate of the fourth transmission gate (TG4) are connected to each other through a first node (D1a),
an NMOS gate of the first transmission gate (TG1), an NMOS gate of the second transmission gate (TG2), a PMOS gate of the third transmission gate (TG3), and a PMOS gate of the fourth transmission gate (TG4) are connected to each other through a second node (D2a),
a first end of the first transmission gate (TG1) is connected to a third node (D3a) and a second end of the first transmission gate (TG1) is connected to the first delay line (DBLEa),
a first end of the second transmission gate (TG2) is connected to a fourth node (D4a) and a second end of the second transmission gate (TG2) is connected to the first delay line (DBLEa),
a first end of the third transmission gate (TG3) is connected to the third node (D3a) and a second end of the third transmission gate (TG3) is connected to a fifth node (D5a), and
a first end of the fourth transmission gate (TG4) is connected to the fourth node (D4a) and a second end of the fourth transmission gate (TG4) is connected to the fifth node (D5a).

7. The memory device (100, 100a) of any one of claims 1 to 6, wherein the memory device is static-random-access memory, SRAM, device.

8. The memory device (100, 100a) of any one of claims 1 to 7, wherein the pulse generator (111) comprises a NAND gate (ND1) having a first input terminal to receive a decoded row address (LRA), a second input terminal to receive the internal clock (ICK), and an output terminal connected to input terminals of the first and second delay circuits (115, 116), and a NOR gate (NR1) having a first input terminal connected to output terminals of the first and second delay circuit (115, 116), a second input terminal to receive an inverted internal clock (ICK_N), and an output terminal connected to the row decoder (130).

9. The memory device (100, 100a) of any one of claims 1 to 8, wherein the first wordline enable signal is transitioned to an activation level after a first interval (TV1) from corresponding rising edge of the internal clock (ICK), the second wordline enable signal is transitioned to an activation level after a second interval (TV2) from corresponding rising edge of the internal clock (ICK), and the first interval (TV1) is longer than the second interval (TV2).

10. The memory device (100, 100a) of any one of claims 1 to 9, wherein a pulse width of the first wordline enable signal is shorter than a pulse width of the second wordline enable signal.

11. A memory device (100, 100b) comprising:
a memory cell array (120) comprising a plurality of memory cells (MC);
a row decoder (130) connected to the plurality of memory cells (MC) through a plurality of wordlines (WL1-WLm);
a column decoder (140) connected to the plurality of memory cells (MC) through a plurality of bitlines (BLT1- BLTN); and
a pulse generator (111) configured to generate an internal clock (ICK) based on a clock received from outside the memory device (100, 100b) and generate a wordline enable signal (WLES) in response to a corresponding edge of the internal clock (ICK), wherein the pulse generator (111) comprises a first switching circuit (117) configured to output a first wordline enable signal to the row decoder (130) based on a first level of a tracking control signal (WEN) after a first time interval from the corresponding edge of the internal clock (ICK), and a second switching circuit (118) configured to output a second wordline enable signal to the row decoder (130) based on a second level of the tracking control signal (WEN) after a second time interval from the corresponding edge of the internal clock (ICK) which is shorter than the first time interval, wherein the first time interval is caused by a second delay line (DBLEb) which is actively electrically connected to the first switching circuit (117) based on the first level of a tracking control signal (WEN).

12. The memory device (100, 100b) of claim 11, wherein the pulse generator (111) comprises an inverter (112_3) having an input terminal connected to the first and second switching circuits (117, 118) and an output terminal connected to the row decoder (130).

13. The memory device (100, 100b) of claim 11 or 12, wherein the pulse generator (111) further comprises an inverter circuit (112_2b) comprising a first inverter (INV1b) and a second inverter (INV2b), and an input terminal of the first inverter (INV1b) receives the tracking control signal (WEN), an output terminal of the first inverter (INV1b) is connected to the first switching circuit (117), and an input terminal of the second inverter (INV2b) is connected to the output terminal of the first inverter (INV1b), and an output terminal of the second inverter (INV2b) is connected to the second switching circuit (118).

14. The memory device (100, 100b) of any one of claims 11 to 13, wherein the first and second switching circuits (117, 118) comprise first and second PMOS transistors (MP1, MP2) and first to sixth NMOS transistors (MN1-MN6),
a gate terminal of the first PMOS transistor (MP1) is connected to a first node (D1b), a power supply voltage (VDD) is applied to a first end of the first PMOS transistor (MP1), and a second end of the first PMOS transistor (MP1) is connected to a second node (D2b),
a gate terminal of the second PMOS transistor (MP2) is connected to a third node (D3b), the power supply voltage (VDD) is applied to a first end of the second PMOS transistor (MP2), and a second end of the second PMOS transistor (MP2) is connected to the second node (D2b),
a gate terminal of the first NMOS transistor (MN1) is connected to the first node (D1b), a first end of the first NMOS transistor (MN1) is connected to the second node (D2b), and a second end of the first NMOS transistor (MN1) is connected to a first end of the third NMOS transistor (MN3),
a gate terminal of the second NMOS transistor (MN2) is connected to the first node (D1b), a first end of the second NMOS transistor (MN2) is connected to the second node (D2b), and a second end of the second NMOS transistor (MN2) is connected to a first end of the fourth NMOS transistor (MN4),
a gate terminal of the third NMOS transistor (MN3) is connected to the third node (D3b) and a second end of the third NMOS transistor (MN3) is connected to a first end of the fifth NMOS transistor (MN5),
a gate terminal of the fourth NMOS transistor (MN4) is connected to the third node (D3b) and a second end of the fourth NMOS transistor (MN4) is connected to a first end of the sixth NMOS transistor (MN6),
a gate terminal of the fifth NMOS transistor (MN5) receives a first tracking control signal obtained by inverting the tracking control signal (WEN) and a second terminal of the fifth NMOS transistor (MN5) is connected to the second delay line (DBLEb), and
a gate terminal of the sixth NMOS transistor (MN6) receives a second tracking control signal obtained by inverting the first tracking control signal and a ground voltage is applied to a second terminal of the sixth NMOS transistor (MN6),
wherein the first and second switching circuits (117, 118) are configured to receive the internal clock (ICK) through the first node (D1b), and receive a decoded row address (LRA) through the third node (D3b).

15. The memory device (100, 100b) of any one of claims 11 to 14, wherein a voltage level of the first wordline enable signal is transitioned to an activation level after a first interval from a corresponding rising edge of the internal clock (ICK), a voltage level of the second wordline enable signal is transitioned to an activation level after a second interval from a corresponding rising edge of the internal clock (ICK), and the first interval is longer than the second interval.
